# EUROPEAN PATENT APPLICATION

(11) **EP 4 406 773 A1**
(43) Date of publication of application: **31.07.2024**
(21) Application number: 23153509.7
(22) Date of filing: 26.01.2023
(51) Int. Cl.: B60L 53/16, B60L 53/302

(54) **EV ADVANCED COOLING DEVICE**

(71) Applicant: ABB E-mobility B.V., 2629 JG Delft (NL)
(72) Inventor: FONDELLI, Tommaso, 50063 Figline e Incisa Valdarno, Firenze (IT); GARCIA-FERRE, Francisco, 5400 Baden (CH); TACCONI, Zeno, 37026 Pescantina (VR) (IT)
(74) Representative: Maiwald GmbH

(57) **Abstract**

The invention relates to the field of charging devices for electric vehicles (EV), particularly for cooling parts, e.g. cables, of charging devices. The invention relates to a cooling arrangement (10) configured for being arranged between a charging connector (20) of an electric vehicle charging system and a charging socket (40) of an electric vehicle, the cooling arrangement (10) comprising:
a power link (30), which is electrically and thermally conductive, configured for being arranged between a charging contact (24) of the charging connector (20) and a socket contact (44) of the charging socket (40), wherein the power link (30) is thermally connected to a cooling unit (16).

## Description

### Field of the Invention

The invention relates to the field of charging devices for electric vehicles (EV), particularly for cooling parts, e.g. cables, of charging devices. The invention further relates to a use.

### Background

For charging electric vehicles, in at least some cases high currents flow through the cables and/or other current conducting parts of a charging device. These high currents may lead to a heating of the cables and/or to a decrease of the current output. This effect may be particularly crucial in a region of transition parts, for instance in an area of connecting plugs.

### Description

It is an objective of the invention to provide an apparatus that allows conducting high currents, at least in some regions of current conducting parts of a charging device. This objective is achieved by the subject-matter of the independent claims. Further embodiments are evident from the dependent claims and the following description.

One aspect relates to a cooling arrangement configured for being arranged between a charging connector of an electric vehicle charging system and a charging socket of an electric vehicle, the cooling arrangement comprising:
a power link, which is electrically and thermally conductive, configured for being arranged between a charging contact of the charging connector and a socket contact of the charging socket, wherein the power link is thermally connected to a cooling unit.

The cooling arrangement configured for being arranged in a region of a plug, particularly between a charging connector of an electric vehicle charging system and a charging socket of an electric vehicle. Analyses have shown that in such a region, caused by high currents, higher temperatures may arise during charging the electric vehicle (EV). The higher temperatures may arise, e.g., due to transitions resistances of the plus itself - i.e. between the so-called charging connector of the electric vehicle charging system and the so-called charging socket of an electric vehicle -, or due to transitions resistances of crimping. Regardless the number of pins of the charging connector, the conductors need to be crimped to the contacts, whose size may be fixed, e.g. by standards, for a given DC connector type. The contact resistance introduced by the electrical contacts may be a strong contributor to the overall thermal resistance of the system. In addition, the crimps on the side of the connector and car inlet may have an important contribution. High resistance under high current means high electric power losses, therefore high temperatures.

High temperatures of the charging connector may not only reduce the maximum current through the cables, because the cables' resistance is increased at higher temperatures. High temperatures of the charging connector may also have a risk to harm persons who handle the charging connector. This is also a reason for some legal and other regulations concerning these parts. For instance, standards like IEC 62196 series or UL 2251 limit the maximum temperature of the electrical contacts, which should not exceed by 50°C the ambient temperature during charging, and must not exceed 90°C in any case, to avoid any possible damage of the cable interface and of the car socket. As regards the temperature of graspable and touchable parts, the standards, e.g. IEC:2010 guide 117, claim that the maximum permissible temperature of parts of connectors or cable that can be grasped during normal operation shall not exceed 60°C, while for non-metal parts that may be touched but not grasped the permissible temperature is up to 85°C.

Hence, the cooling arrangement leads, when arranged between the charging connector and the charging socket, advantageously not only to a reduction of the temperature of the plugs - and, thus, of the handle -, but additionally to a reduction of the temperature of neighbouring current conducting parts of a charging device, for example of crimping regions. The cooling arrangement may be implemented as part of the charging connector, as part of the charging socket, and/or as a "box" of its own. The cooling arrangement may be called an Advanced Cooling Device (ACD). As a result, the cooling arrangement may enable higher charging currents than the maximum feasible and/or allowed currents without this cooling arrangement.

The cooling arrangement realized by a power link, which may be positioned in a central region of the cooling arrangement. The power link is of a material that is electrically and thermally conductive, for instance copper or the like. The power link is configured for being arranged between a charging contact of the charging connector and a socket contact of the charging socket. The power link may, depending on the standard of the charging connector, be implemented as a plurality of parts, for example one power link for each high-current conducting wire of a charging cable, e.g. for each DC+ and DC-wire of a DC charger. The power link may have, on one end, a male part for connecting to the charging connector and, on another end, a female part for connecting to the charging socket. The power link is thermally connected to the cooling unit. Between the end parts of the power link (at its "core"), the power link may have any form, but may be preferably plane, to have a broadest possible contact to the cooling unit. Of course, for cooling units of other optimized forms, another form of the power link's core may be selected.

In various embodiments, the power link comprises or consists of metal, particularly of copper, aluminium, and/or an alloy comprising at least one of these metals. These materials are advantageously highly electrically and thermally conductive, thus both causing lower temperatures for current flowing through the power link and providing a good thermal connection to the cooling unit.

In various embodiments, a coupling component is arranged between the power link and the cooling unit, the coupling component comprising an electrically isolating and thermally conductive material. Examples of such a material may comprise ceramics, e.g. Al₂O₃, TiC, WC, ZrO₂, AIN, SiC, or similar, preferably AIN and Al₂O₃, because of a high thermal conductivity and cost efficiency. Further examples may comprise plastics that are electrically insulating and Also thermally conductive, however in many cases with an order of magnitude lower thermal conductivity compared to ceramics. For instance. Al₂O₃ has an value of about 30 W/mK, and plastics about 0.2 W/mK. The coupling component may comprise one or more layers. The coupling component may contribute to a good isolation between different power links, thus preventing a short and keeping the cooling arrangement small. The coupling component may contribute to a thermal balance between the parts of the cooling arrangement, thus reducing a thermal stress of these parts.

In various embodiments, the charging connector is connected to the power link either via a female socket or via a male pin, and/or the charging socket is connected to the power link either via a male pin or via a female socket. This may depend on the standards to be supported. The charging connector may support and/or may be compatible to standards like CHAdeMO, GB/T, CCS - Type 1, CCS - Type 2, MCS, and/or other standards. Non-standard (proprietary) solutions may be supported as well. In at least some embodiments, the charging connector may be applied not only to a charging device for electric vehicles, but also to devices where high currents may lead to similar restrictions as explained above. The charging connector may comprise a plurality of pins, depending on the connector.

The contacts of the female socket and/or the male pin may be coated, e.g. for a higher electric and/or thermal conductivity. The coating may include gold, silver, palladium, nickel, other highly conducting materials and/or an alloy of these materials.

In some embodiments, the cooling arrangement may further comprise a housing for covering at least the power link and the cooling unit and, optionally, a charging interface configured for coupling the charging connector, and/or a socket interface configured for coupling the charging socket.

For instance, an integrated solution for a charging connector may include only the charging interface and may, e.g., be part of the charging connector and/or the charging handle. Another example may be an integrated solution for an electric vehicle that may include only the socket interface, thus being part of the EV. Another solution may be a "box" of its own, i.e. the cooling arrangement's parts arranged in the housing. The charging interface and/or the socket interface may - at least partially - be covered by the housing. The cooling arrangement may be called an Advanced Cooling Device (ACD). The ACD may be compatible to standards, e.g. the ones listed above, or to a proprietary solution.

In an embodiment, the cooling effect of the cooling unit is achieved by dissipating heat through a finned surface and/or a heat pipe via natural air convection. This may be realized by a collector block with embedded heat pipes that collects the heat from the DC power link, dissipating through a finned surface via natural convection. This design may be similar to a Javelin connector. In this case, no fans are used hence no battery is needed, However, the cooling capabilities of this embodiment may be limited.

In an embodiment, the cooling effect of the cooling unit is achieved by a combined heat pipe-forced convection cooling. This embodiment may have similarities with a high-end CPU cooling that has a high-power dissipation capability. Advantageously, combined heat pipe-forced convection cooling methods are well established and a lot of suppliers are available.

In an embodiment, a collector block with embedded heat pipes may be used for cooling. In this case, the collector block collects the heat from the DC power link, and dissipates it through a finned surface with a fan. The fan may be driven by a battery and/or by other power sources. For example, for portable solutions, the device may be fed by an embedded battery, and for integrated solutions the low voltage power may be provided by a hosting unit.

In an embodiment, the cooling effect of the cooling unit is achieved by a forced air convection combined with an advanced heat sink. For instance, so-called 3D vapor chamber technology may be used for an enhanced cooling effect. Vapor chambers and heat pipes may be combined, creating a closed vapor chamber system. In this solution, the warmed liquid is dissipated up through the fin assembly of the cooler.

Additionally or as an alternative, a coolant fluid (e.g. a flow) may be used to extract heat from the substrate with an enhanced global heat transfer coefficient. Depending on the characteristics of the cooling block and of the flow, high heat rejections may be achieved. This solution may particularly suit for automotive application since water-glycol cooling loops are already present in the vehicle.

In an embodiment, the cooling effect of the cooling unit is achieved by active cooling, particularly by a Peltier cell. This kind of device allows active cooling of the heat source thanks to the Seebeck effect. A Peltier thermoelectric module consists of P-type and N-Type Bismuth Telluride semiconductor pellets. These are separated by ceramic substrates, which are metalized to allow the conduction of heat from the "cool" to the "hot" side of the module when connected to a dc voltage source. Peltier cell solution allows the power link to exchange heat with a source at a temperature below the ambient one. This kind of solution may even be feasible for cooling in very hot climate areas with severe thermal conditions.

An aspect relates to a use of a cooling arrangement as described above and/or below for lowering a temperature of a charging contact, a socket contact, a power link and/or another current carrying part of a charging system for charging electric vehicles.

It should be noted that two or more embodiments described above and/or below can be combined, as far as technically feasible.

For further clarification, the invention is described by means of embodiments shown in the figures. These embodiments are to be considered as examples only, but not as limiting.

### Brief Description of the Drawings

- **Fig. 1**: schematically a current output of a charging connector as function of charging time;
- **Fig. 2**: schematically a current output of a charging connector as function of temperature;
- **Fig. 3**: schematically an embodiment;
- **Fig. 4**: schematically an embodiment;
- **Fig. 5**: schematically a systematic of embodiments;
- **Fig. 6**: schematically a part of an embodiment;
- **Fig. 7**: schematically a part of an embodiment;
- **Fig. 8**: schematically a part of an embodiment;
- **Fig. 9**: schematically a part of an embodiment;
- **Fig. 10**: schematically a part of an embodiment.

### Detailed Description of Embodiments

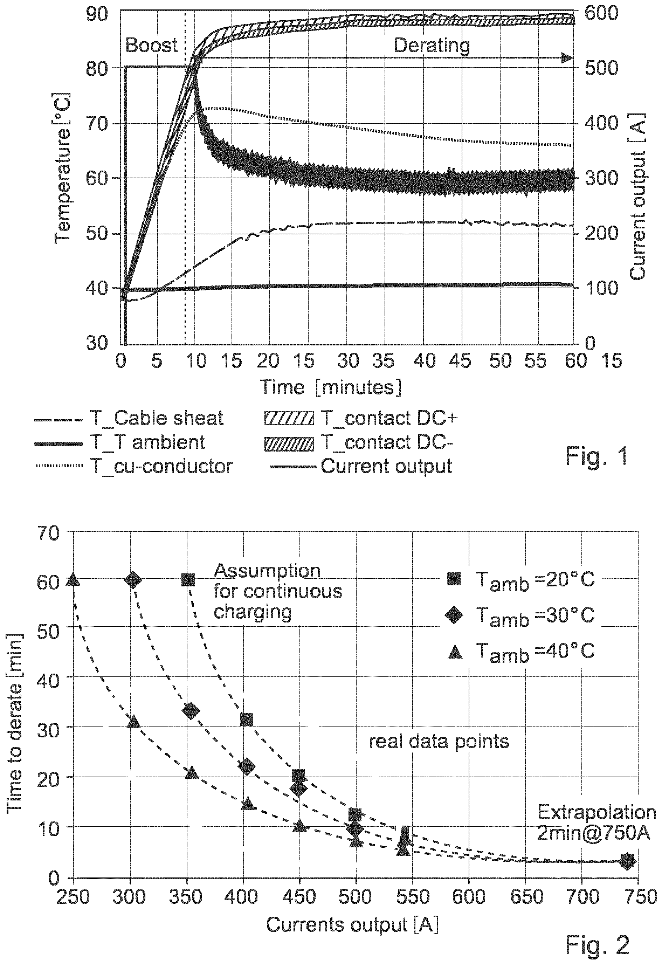

During a charging session of an electric vehicle, high currents may flow through the cables and/or other current conducting parts of a charging device. These high currents may lead to a heating of the cables and/or to a decrease of the current output. **Fig. 1** shows schematically a current output of a charging connector as function of charging time, which quantifies this effect. Particularly, **Fig. 1** shows results of a boost mode at 500 A test done in ABB laboratories with a commercial 300 A nominal rating charging connector, plugged into a 90 mm² inlet-socket, at an ambient temperature T_ambient of about 40°C. Although **Fig. 1** only shows a situation of a DC charger, an AC charger behaves in a similar way. As can be seen, after about 8 minutes of charging, the temperature T_contact_DC+ of the DC+ contact and the temperature T_contact_DC-of the DC- contact rise above 80°C. About 10 minutes later, also the temperature T_Cable_sheath of the cable sheath rises above 50°C, which makes a handling of the charging connector less agreeable. Furthermore, the current output decreases significantly, from its 500 A peak down to about 300 A, on long term. This, in effect, decreases the temperature T_cu-conductor of the conductor, but does not lead to a higher current output. As a result, after derating the current output stays at about 295 A. It is clearly visible that a lower temperature at the (DC+ and DC-) contacts leads to a significantly higher current output.

For evaluating an influence of an ambient temperature, **Fig. 2** shows schematically a current output of a charging connector as function of temperature, using 70 mm² socket inlet. Measurements are also taken at ambient temperatures of 20°C, 30°C and 40°C. The chart shows the relationship between the current output at regime condition, and the boost mode duration as well, with ambient temperature. At 40°C ambient temperature the connector can deliver continuously 250 A instead of the rated 300 A. Lower ambient temperatures may allow higher continuous current deliver, e.g. 300 A for 30°C and 350 A for 20°C.

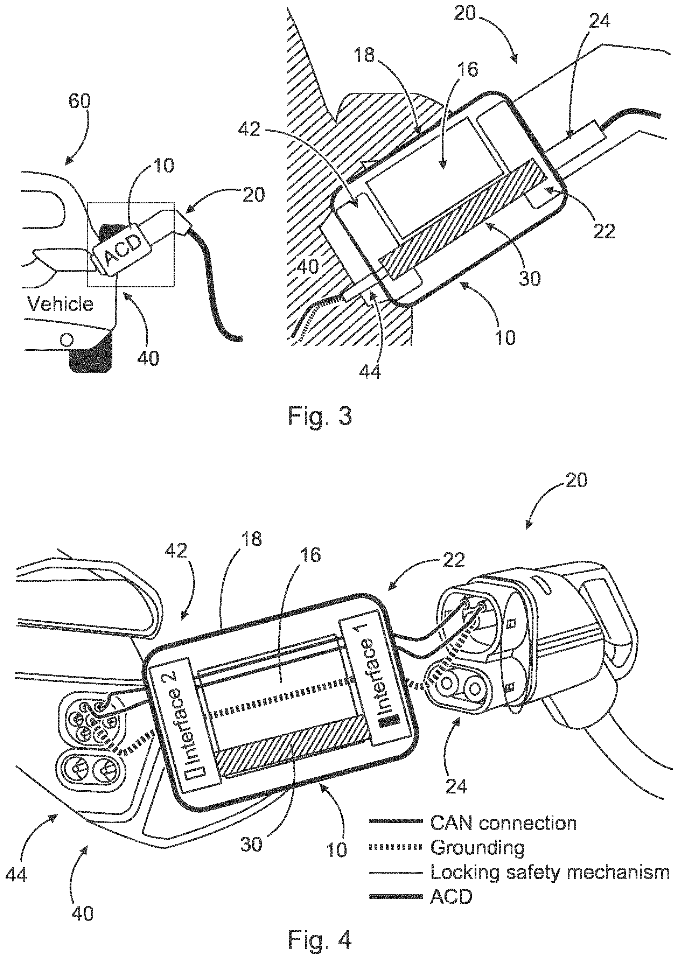

**Fig. 3** shows schematically an embodiment. **Fig. 3** left hand shows roughly, where an ACD (Advanced Cooling Device) is intended to be positioned, i.e. between a charging socket 40 of a car or EV 60 and a charging connector 20. **Fig. 3** right hand shows details of an embodiment of the ACD. The ACD is designed as a cooling arrangement 10 that comprises a housing 18. The housing 18 covers a power link 30 and a cooling unit 16, which is thermally connected to the power link 30. The power link 30 is electrically and thermally conductive, e.g. consisting of a metal. In **Fig. 3****,** the power link 30 is arranged between a charging contact 24 of the charging connector 20 and a socket contact 44 of the charging socket 40. In some embodiments, a coupling component 12 (not shown) may be arranged between the power link 30 and the cooling unit 16.

In the housing 18, further a charging interface 22 and a socket interface 42 is arranged. The charging interface 22 is configured for coupling the charging connector 20, and is designed similarly to the charging socket 40. The socket interface 42 is configured for coupling the charging socket 40. For charging, the cooling arrangement 10 can be plugged into the charging socket 40 of the EV, and the charging connector 20 can be plugged into the cooling arrangement 10. This embodiment of cooling arrangement 10 can be brought by an own of an EV, who comes for charging, and/or can be provided by service personnel that runs the charging station.

In another embodiment (not shown), the cooling arrangement 10 may be installed in the car 60, at a region of the charging socket 40. This embodiment may be available without a socket interface 42, and the charging interface 22 may look like an original charging socket 40 of the EV. In yet another embodiment (not shown), the cooling arrangement 10 may be installed in the charging connector 20. This embodiment may be available without a charging interface 22, and the socket interface 42 may look like an original charging connector 20. These embodiments may be called an "integrated solution"; they may be combined.

**Fig. 4** shows schematically an embodiment, e.g. the embodiment of **Fig. 3** in some more details. Same reference signs as in **Fig. 3** depict same of similar components. The ACD is shown before the charging session, i.e. not plugged yet, and the additional wires - other than DC+ and DC-, e.g. Protective Earth (PE) - are depicted in a symbolic way to show their connectivity. Further additional wires may also be "forwarded" in the ACD, e.g. communication cables, for example of a CAN bus, and/or other cables, which may not be intended to carry high currents.

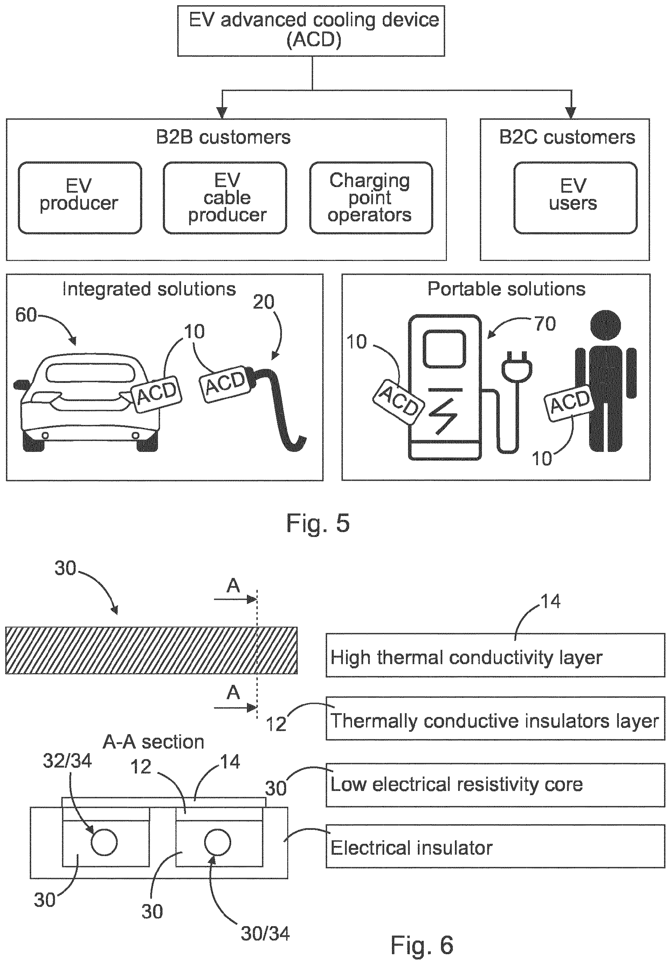

**Fig. 5** shows schematically a systematic of embodiments. An ACD may either be sold to B2B (business to business) customers or to B2C customers. B2B customers may use an ACD as an integrated solution. An EV producer may install such an integrated solution within an EV 60. A cable producer may install an integrated solution as part of a charging connector 20. Charging point operators and/or service personnel that runs the charging station may lend or sell a stand-alone ACD (in a housing) for a charging session. B2C customers may buy a stand-alone ACD for charging sessions.

**Fig. 6** shows schematically a part of an embodiment, particularly an embodiment of a coupling component 12 and 14 that is arranged between the power link 30 and the cooling unit 16 (not shown), which is to be arranged on top of coupling component 14. The power link 30 may have, at its end, a female pin 32 or a male pin 34. The power link 30 may, at its core, be rectangular, particularly with a plane surface towards the cooling unit 16 or to the coupling component 12 and/or 14, respectively. The power links 30 may be separated by an electrical insulator. A first coupling component 12 may be designed as an electrically isolating and thermally conductive material. This coupling component may contribute to a good isolation between different power links, thus preventing a short and keeping the cooling arrangement small. The cooling arrangement may comprise a second coupling component 14. The second coupling component 14 may be designed as a high thermal conductivity layer. The second coupling component 14 may contribute to a thermal balance between the parts of the cooling arrangement, thus reducing a thermal stress of these parts.

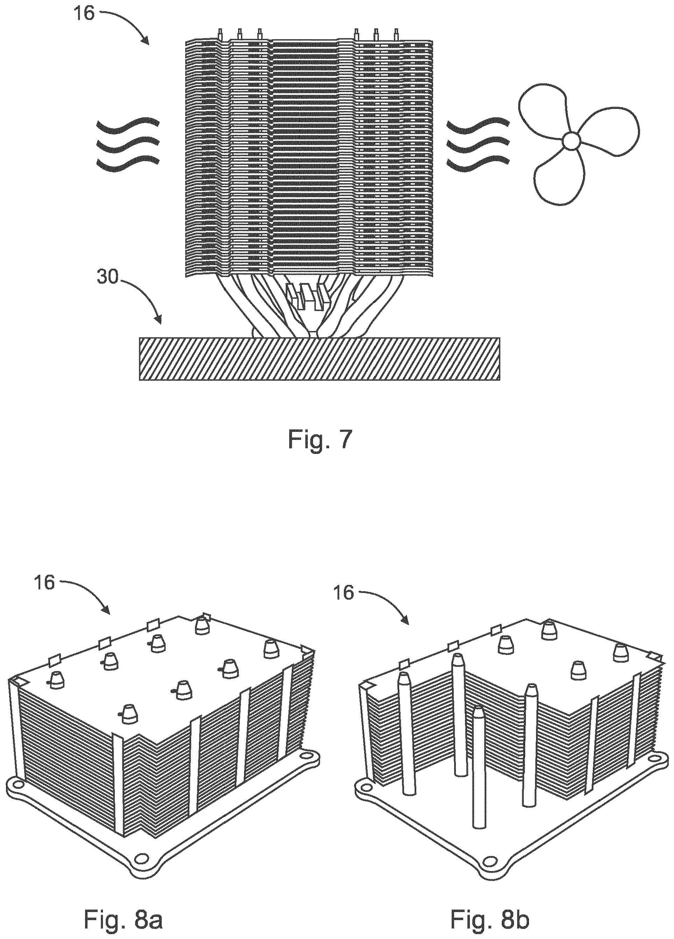

**Fig. 7** shows schematically a part of an embodiment, particularly an embodiment of a cooling unit 16. In this embodiment, a collector block with embedded heat pipes is used for cooling. In this case, the collector block collects the heat from the DC power link, and dissipates it through a finned surface with a fan. The fan may be driven by a battery and/or by other power sources. For example, for portable solutions, the device may be fed by an embedded battery, and for integrated solutions the low voltage power may be provided by a hosting unit.

**Fig. 8a** and **8b** show schematically a part of an embodiment, particularly an embodiment of a cooling unit 16. In this embodiment, the cooling effect of the cooling unit is achieved by a forced air convection combined with an advanced heat sink. For instance, so-called 3D vapor chamber technology may be used for an enhanced cooling effect. Vapor chambers and heat pipes may be combined, creating a closed vapor chamber system. In this solution, the warmed liquid is dissipated up through the fin assembly of the cooler. **Fig. 8a** shows a complete version of this embodiment. **Fig. 8b** shows a partly cut-off version of this embodiment.

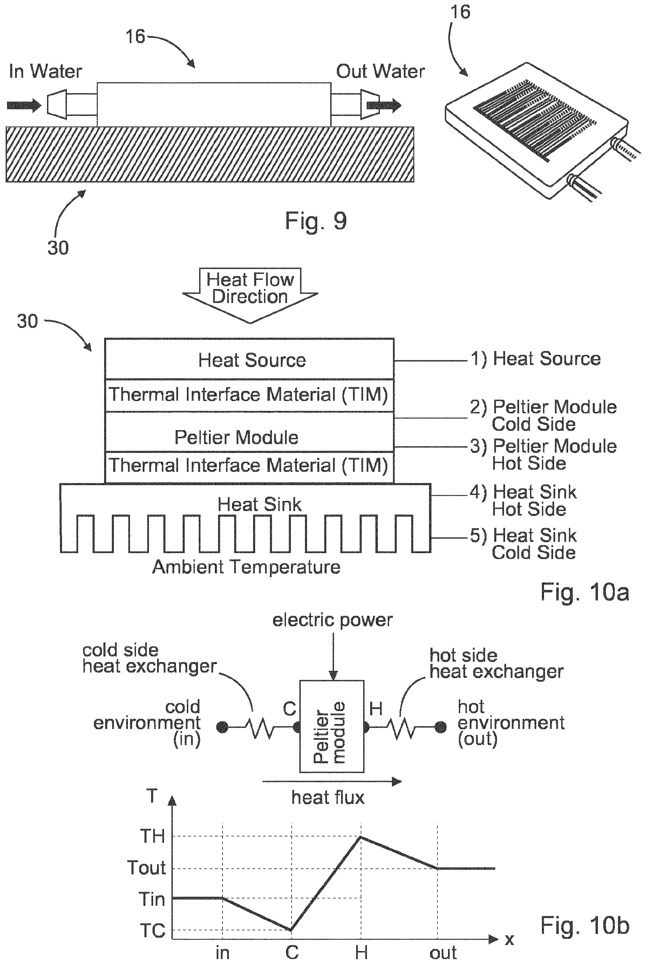

**Fig. 9** shows schematically a part of an embodiment, particularly an embodiment of a cooling unit 16. In this embodiment, the cooling effect of the cooling unit is achieved by a forced coolant fluid convection combined with an advanced heat sink. In this solution, a coolant fluid (e.g. a flow) may be used to extract heat from the substrate with an enhanced global heat transfer coefficient. Depending on the characteristics of the cooling block and of the flow, high heat rejections may be achieved. This solution may particularly suit for automotive application since water-glycol cooling loops are already present in the vehicle.

**Fig. 10a** and **10b** show schematically a part of an embodiment, particularly an embodiment of a cooling unit 16. In this embodiment, the cooling effect of the cooling unit is achieved by active cooling, particularly by a Peltier cell. This kind of device allows active cooling of the heat source thanks to the Seebeck effect. Peltier cell solution allows the power link to exchange heat with a source at a temperature below the ambient one. This kind of solution may even be feasible for cooling in very hot climate areas with severe thermal conditions. **Fig. 10a** shows the exemplary layers of such a cooling unit 16. The heat source (1), i.e. power link 30 transmits its heat, via a first thermal interface material (TIM), through a cold side (2) of the Peltier cell towards its hot side (3). The heat is further transmitted via a second TIM to a heat sink cold side (5) for being dissipated to an ambient. **Fig. 10b** shows schematically a het flux and a thermal profile of this embodiment.

### List of Reference Symbols

- 10: cooling arrangement
- 12, 14: coupling component
- 16: cooling unit
- 18: housing
- 20: charging connector
- 22: charging interface
- 24: charging contact
- 30: power link
- 32: female pin
- 34: male pin
- 40: charging socket
- 42: socket interface
- 44: socket contact
- 50: charging cable
- 60: car, EV
- 70: charging station

## Claims

1. A cooling arrangement (10) configured for being arranged between a charging connector (20) of an electric vehicle charging system and a charging socket (40) of an electric vehicle, the cooling arrangement (10) comprising:
a power link (30), which is electrically and thermally conductive, configured for being arranged between a charging contact (24) of the charging connector (20) and a socket contact (44) of the charging socket (40),
wherein the power link (30) is thermally connected to a cooling unit (16).

2. The cooling arrangement (10) of claim 1,
wherein the power link (30) comprises or consists of metal, particularly of copper, aluminium, and/or an alloy comprising at least one of these metals.

3. The cooling arrangement (10) of claim 1 or 2,
wherein a coupling component (12) is arranged between the power link (30) and the cooling unit (16),
the coupling component (12) comprising an electrically isolating and thermally conductive material.

4. The cooling arrangement (10) of any one of the preceding claims,
wherein the charging connector (20) is connected to the power link (30) either via a female socket (32) or via a male pin (34), and/or
the charging socket (40) is connected to the power link (30) either via a male pin (34) or via a female socket (32).

5. The cooling arrangement (10) of any one of the preceding claims, further comprising:
a housing (18) for covering at least the power link (30) and the cooling unit (16) and, optionally,
a charging interface (22) configured for coupling the charging connector (20), and/or
a socket interface (42) configured for coupling the charging socket (40).

6. The cooling arrangement (10) of any one of the preceding claims,
wherein the cooling effect of the cooling unit (16) is achieved by dissipating heat through a finned surface and/or a heat pipe via natural air convection.

7. The cooling arrangement (10) of any one of the preceding claims,
wherein the cooling effect of the cooling unit (16) is achieved by a combined heat pipe-forced convection cooling.

8. The cooling arrangement (10) of any one of the preceding claims,
wherein the cooling effect of the cooling unit (16) is achieved by a forced coolant fluid convection combined with an advanced heat sink.

9. The cooling arrangement (10) of any one of the preceding claims,
wherein the cooling effect of the cooling unit (16) is achieved by active cooling, particularly by a Peltier cell.

10. Use of a cooling arrangement (10) of any one of the preceding claims for lowering a temperature of a charging contact (24), a socket contact (44), a power link (30) and/or another current carrying part of a charging system for charging electric vehicles.
